# EUROPÄISCHE PATENTSCHRIFT

(11) **EP 0 794 014 B1**
(45) Veröffentlichungstag und Bekanntmachung des Hinweises auf die Patenterteilung: **11.09.2002**
(21) Anmeldenummer: 97103420.2
(22) Anmeldetag: 03.03.1997
(51) Int. Cl.: B05D 1/00, B05D 7/24

(54) **Verfahren und Einrichtung zur Hochfrequenz-Plasmapolymerisation**
Process and apparatus for high frequency plasma polymerization
Procédé et appareil pour polymériser avec un plasma à haute fréquence

(30) Priorität: 04.03.1996 DE 19608158
(43) Veröffentlichungstag der Anmeldung: 10.09.1997
(73) Patentinhaber: VTD Vakuumtechnik Dresden GmbH, 01257 Dresden (DE)
(72) Erfinder: Falz, Michael, 01169 Dresden (DE); Solger, Norbert, 01259 Dresden (DE); Wilberg, Rüdiger, 01259 Dresden (DE); Poll, Hans-Ullrich, Prof. Dr., 09127 Chemnitz (DE); Schreiter, Steffen, Dr., 09669 Frankenberg (DE); Böhme, Siegfried, 09127 Chemnitz (DE)
(74) Vertreter: Pätzelt, Peter, Dipl.-Ing.

(56) Entgegenhaltungen:
- EP-A- 0 533 606
- WO-A-91/12092
- DE-A- 2 302 190
- DE-A- 2 903 291
- DE-A- 4 318 084
- FR-A- 2 328 025
- US-A- 3 397 132

## Beschreibung

Die Erfindung betrifft ein Verfahren zur Hochfrequenz-Plasmapolymerisation für die Abscheidung von Polymerschichten auf der Oberfläche von Substraten nach dem Oberbegriff des Anspruchs 1. Des weiteren betrifft die Erfindung eine Einrichtung nach dem Oberbegriff des Anspruchs 5 bzw. des Anspruchs 6, insbesondere für die Anwendung in Chargenanlagen, in denen jeweils eine Vielzahl von Substraten beschichtet werden soll.

Nach dem Stand der Technik sind Verfahren und Einrichtungen zur Plasma-Polymerisation für ein sehr breites Anwendungsgebiet bekannt. Eine wesentliche Anwendung liegt bei der Abscheidung von optisch transparenten Schutzschichten auf Substraten; die ihrerseits optische Schichten aufweisen. Es sind jedoch auch viele andere technische Anwendungen der Schichten bekannt, wie die Ausnutzung der guten Gleiteigenschaften von Polymerschichten, die antikorrosiven Schutzeigenschaften oder die mechanischen Schutzeigenschaften, z. B. für Schichten mit elektrischen Eigenschaften, wie Abschirmschichten.

Die DE AS 26 25 448 gibt als Beispiel ein Verfahren und eine Vorrichtung zur Herstellung einer Schutzschicht auf der Oberfläche optischer Reflektoren an. Die optischen Reflektoren sind aus Metall und auf der Oberfläche ist ein glättender Tauchlack aufgebracht, auf dem sich eine Reflexionsschicht in Form einer dünnen hochreflektierenden Aluminiumschicht befindet. Zum Schutz der Aluminiumschicht gibt die Druckschrift ein Verfahren zur Abscheidung einer Polymerschicht an. Die Polymerschicht wird durch Plasma-Polymerisation abgeschieden. Dazu werden die Reflektoren einem monomeren Dampf organischer Verbindungen ausgesetzt, wobei mit Hilfe der Strahlung einer elektrischen Gasentladung auf der Reflektorschicht durch Polymerisation eine Schutzschicht, z. B. eine siliziumorganische Schicht ausgebildet wird. Als Strahlung wird beispielsweise eine unselbständige Gasentladung durch Glühemission zwischen zwei Elektroden angegeben. Dazu wird innerhalb des Rezipienten ein Verdampferdraht angeordnet, der auf Glühemissionstemperatur erhitzt wird. Die Substrate, hier metallische Reflektoren, liegen auf Masse und bilden mit dem Rezipienten eine Elektrode der Entladung.

Diese Lösung weist eine relativ geringe Abscheidegeschwindigkeit der Polymerschicht auf und die Niederschlagung des Polymers erfolgt im starken Maße auch auf anderen Oberflächen im gesamten Rezipienten. Letzteres ist sehr unerwünscht und führt zu erheblichem Wartungsaufwand für die Anlagen.

Zur Vermeidung der Nachteile der vorgenannten Lösung, mit einer in der Vakuumkammer offenen Gasentladung, wurde auch versucht, den Plasmaraum einzugrenzen und auf die Substrate zu konzentrieren.

In der EP 424 620 A2 wird eine Einrichtung angegeben, bei der sich zwei flächige Elektroden gegenüberstehen, wovon eine Elektrode über ein Anpaßnetzwerk an einen Pol eines Hochfrequenzgenerators geschaltet ist, während die andere Elektrode mit der Vakuumkammer auf Masse liegt. Das Anpaßnetzwerk und der Hochfrequenzgenerator befinden sich dabei außerhalb der Vakuumkammer. Zwischen den beiden flächigen Elektroden bildet sich ein räumlich begrenztes Plasma aus, wobei zum Zwecke der Polymerisation ein geeignetes Gas in diesen Raum eingeleitet wird. Mittels einer isoliert angeordneten Substrathalterung werden die zu beschichtenden Substrate zwischen den beiden Elektroden angeordnet und beidseitig eine Polymerschicht abgeschieden. Bei dieser Lösung wird die Form und Größe der zu beschichtenden Substrate sehr stark vom Abstand der beiden Elektroden zueinander begrenzt.

Wohlrab u. a. beschreiben in "Plasma Polymerization of Optical Coatings on Organic Substrates: Equipment and Processes", 38th Annual Technical Conference Proceedings (1995) Society of Vacuum Coaters, die Abscheidung von Schutzschichten auf optischen Linsen aus einem Plast, z.B. Polycarbonate oder das als CR39 bekannte Material, mittels Hochfrequenz-Plasma-Polymerisation. Das System besteht aus einer zylindrischen Hochfrequenz-Elektrode in einer zylindrischen Vakuumkammer. Ein karussellartiger Substrathalter rotiert innerhalb des Ringspaltes zwischen der Hochfrequenz-Elektrode und der radialen Wand der Vakuumkammer. Von der Elektrode als Kopf (Matchbox) der Hochfrequenz-Erzeugereinheit ausgehend, wird das Gas innerhalb des Ringspaltes angeregt und ein auf diesen Raum begrenztes Plasma erzeugt. Die Substrate werden axial innerhalb einer Substrathalterung in diesen ringförmigen Raum eingebracht und während der Plasma-Polymerisation allseitig beschichtet.

Der Vorteil der Lösungen mit einem räumlich begrenztem Plasma besteht insbesondere darin, daß gegenüber der "klassischen" Plasma-Polymerisation in einer komplexen Vakuumkammer eine relativ hohe Plasmadichte und damit hohe Abscheideraten erzielt werden. Nachteilig ist jedoch, daß die Anlagenkonfiguration eng an die jeweiligen Substratgeometrie angepaßt werden muß. Es ist auch davon auszugehen, daß die Beschichtung größerer Substrate, wie Auto-Scheinwerfer, mit dieser Anlagenkonfiguration nicht wirtschaftlich realisiert werden kann. Des weiteren ist nachteilig, daß sich die Substrate auf floatendem Potential im Plasmaraum befinden und dadurch die Plasmaausbildung unmittelbar an der Substratoberfläche begrenzt ist.

Wenn die Hochfrequenz-Plasma-Polymerisation in größeren Anlagen ausgeführt werden soll, dann besteht nach dem Stand der Technik ein wesentlicher Nachteil darin, daß alle Hochfrequenz führenden Leitungen mit einem regelmäßig unvertretbar hohem technischen Aufwand mittels Abschirmungen vor Abscheidungen aus der Plasmapolymerisation geschützt werden müssen, da diese sonst unerwünscht besonders stark beschichtet werden.

Der Erfindung liegt die Aufgabe zugrunde, ein Verfahren zur Hochfrequenz-Plasmapolymerisation für die Abscheidung von Polymerschichten auf der Oberfläche von Substraten anzugeben, bei dem die Abscheidung der Polymerschichten mit hohen Abscheidegeschwindigkeiten und konzentriert auf die Oberflächen der Substrate erfolgt. Des weiteren liegt der Erfindung die Aufgabe zugrunde, Einrichtungen für die Abscheidung von Polymerschichten auf der Oberfläche von Substraten anzugeben, bei dem die Abscheidung der Polymerschichten in einer Beschichtungskammer mit hohen Abscheidegeschwindigkeiten erfolgt und die Plasmapolymerisation auf die Oberflächen der Substrate konzentriert wird und übrige Einbauten der Beschichtungskammer nicht wesentlich beschichtet werden.

Insbesondere sollen auch größere Substrate oder eine Vielzahl von Substraten in größeren Anlagen wirtschaftlich beschichtet werden können.

Die Erfindung löst die Aufgabe für das Verfahren durch die im kennzeichnenden Teil des Anspruchs 1 genannten Merkmale. Die Aufgabe für die Einrichtungen wird durch die in den kennzeichnenden Teilen der Ansprüche 5 bzw. 6 angegebenen Merkmale gelöst. Weiterbildungen der Erfindung sind in den Unteransprüchen gekennzeichnet.

Das Wesen der Erfindung besteht dabei darin, daß die tatsächliche Endstufe der Hochfrequenz-Erzeugereinheit, d.h. das Bauteil, mit dem verfahrensgemäß die plasmaerzeugende hochfrequente Spannung erzeugt wird, mit den Substraten räumlich weitgehend direkt verbunden ist.

Die Hochfrequenz-Gasentladung und damit auch das sich bei der Gasentladung ausbildende Plasma wird auf die Oberfläche der Substrate konzentriert. Die Substrate liegen nicht wie beim Stand der Technik passiv im Gasentladungsraum, sondern sie sind eine Elektrode der Hochfrequenz-Gasentladung.

Die Gasentladung führt zur Ausbildung eines dichten Plasmas in einer elektrodennahen Randschicht, die die Elektrode mit konstantem Abstand umhüllt.

Dabei hat sich gezeigt, daß sich die schichtbildenden Teilchen aus dem anwesenden Monomer vornehmlich in dieser elektrodennahen Randschicht ausbilden, also unmittelbar an der Oberfläche der Substrate. In größeren Anlagen, insbesondere in Chargenanlagen, wird die Oberfläche eines als Elektrode wirkenden Substrates derart begrenzt, daß ein optimales Plasma an dieser Substratoberfläche erzielt wird.

Grundsätzlich kann die Endstufe der Hochfrequenz-Erzeugereinheit, die die Transformation der Betriebsspannung auf die zum Zünden der Gasentladung nötige hochfrequente Spannung vornimmt, an beliebiger Stelle innerhalb oder außerhalb der Beschichtungsanlage angeordnet werden.

Als vorteilhaft hat es sich erwiesen, wenn die jeweilige Endstufe der Hochfrequenz-Erzeugereinheit in unmittelbarer Nähe oder in baulicher Einheit zum Substrat bzw. zur Substrathalterung angeordnet ist, da die gleichmäßige Verteilung der Plasmaleistung auf alle Elektrodenteile und die Übertragung von Hochfrequenzen mit technischen Problemen verbunden ist.

Eine weitergehende wesentliche Lösung der Erfindung ist die, daß bei einer Vielzahl von Substraten die einzelnen Substrate oder einzelne Gruppen von Substraten mit je einer tatsächlichen Endstufe entsprechend vieler separater Hochfrequenz-Erzeugereinheiten verbunden sind.

Bei geeigneter Anlagenkonfiguration, z. B. wenn die Substrate oder Substrathalterungen unmittelbar an der Außenwand der Beschichtungs- und Vakuumkammer angeordnet sind, können die tatsächlichen Endstufen, wie auch die sonstigen Elemente der Hochfrequenz-Erzeugereinheiten, außerhalb der Beschichtungskammer angeordnet sein. Vorteilhafter ist jedoch die Lösung nach Anspruch 6, bei der die einzelnen Endstufen innerhalb der Beschichtungskammer angeordnet sind.

Bei Durchlaufanlagen, z. B. zur Beschichtung von Bandmaterialien, können als Substrathalterung Substratträger verwendet werden, die in äquivalenter Weise wie bei Chargenanlagen mit je einer einzelnen separaten Endstufe einer Hochfrequenz-Erzeugereinheit kontaktiert sind.

Die Vorteile der Erfindung bestehen insbesondere darin, daß die Abscheidung der Polymerschicht mit hoher Geschwindigkeit erfolgt, keine wesentlichen elektrischen Verluste auftreten und eine hohe Ausnutzung des eingesetzten dampfförmigen Monomers erfolgt, da die Substrate selbst oder die Substrathalterungen unmittelbar als Elektroden der Hochfrequenz-Plasmaentladung geschaltet werden. Dadurch befinden sich die Substrate im Kernfeld der Plasmapolymerisation. Bei Anordnung der tatsächlichen Endstufen der Hochfrequenz-Erzeugereinheiten innerhalb der Beschichtungskammer, werden Leitungen vermieden, die eine plasmaerzeugende hochfrequente Spannung übertragen und dadurch im besonderen Maße unerwünscht mit dem jeweiligen Polymer beschichtet werden.

Die Erfindung soll nachstehend an zwei Ausführungsbeispielen näher erläutert werden.

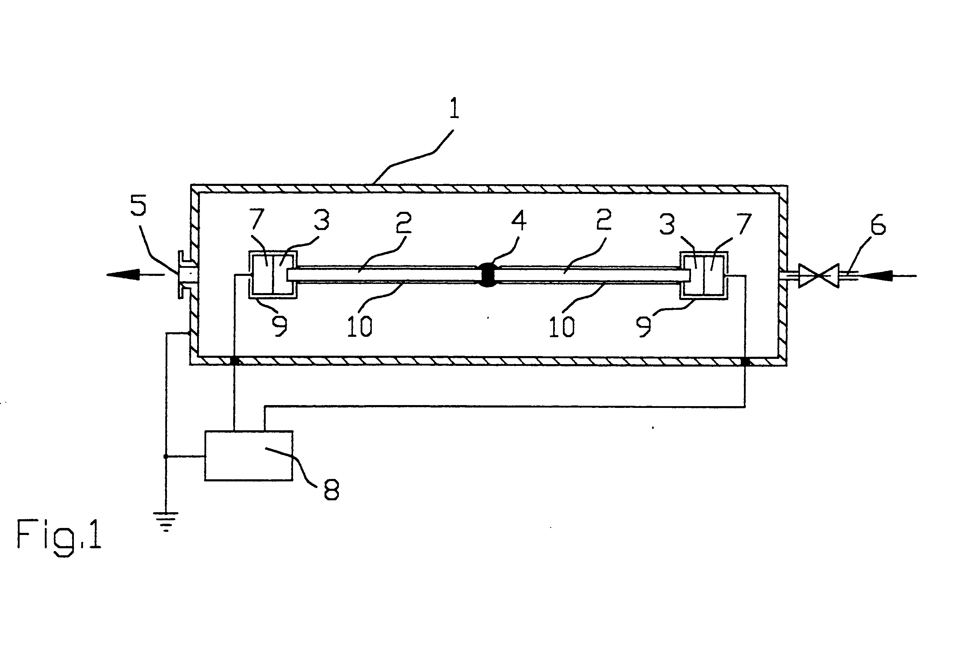

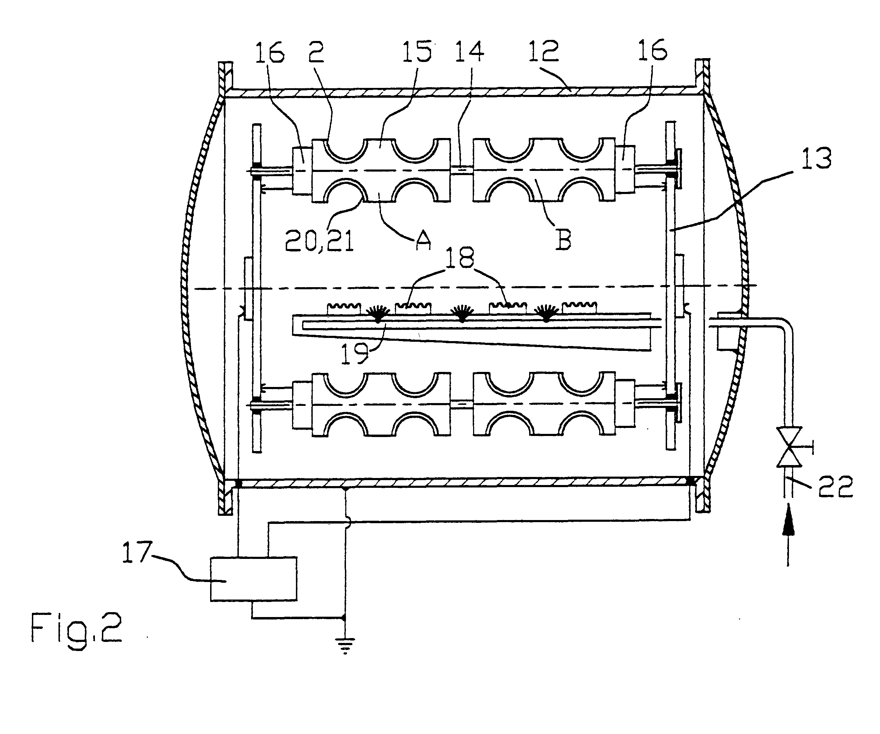

Die zugehörigen Zeichnungen zeigen in Figur 1 im Schnitt eine schematische Beschichtungskammer zur Anwendung der erfindungsgemäßen Lösung bei einzelnen Substraten. Figur 2 zeigt eine große Beschichtungskammer mit einer Vielzahl von Substraten in Substrathalterungen.

### Ausführungsbeispiel I

Im Ausführungsbeispiel I soll die Erfindung bei der Anwendung zur Beschichtung einzelner Substrate mit einer Polymerschicht dargestellt werden. In Figur 1 sind beispielhaft in einer Beschichtungskammer 1 zwei Substrate 2 jeweils in einer Substrathalterung 3 gehaltert. Als Substrate 2 sind im Beispiel metallische Platten dargestellt. Die Substrate 2 sind leitend in den Substrathalterungen 3 gehaltert. Zwischen den Substrathalterungen 3 befindet sich ein Isolierkörper 4. Die Beschichtungskammer 1 weist einen Vakuumanschluß 5 auf, über den die Beschichtungskammer 1 an eine Vakuumpumpeinheit angeschlossen ist. Dem Vakuumanschluß 5 gegenüber befindet sich ein Gaseinlaß 6, über den wahlweise ein Inertgas, ein Reaktivgas und/oder ein Monomer in die Beschichtungskammer 1 eingelassen werden kann.

An den Substrathalterungen 3 sind unmittelbar je eine separate Endstufe 7 einer Hochfrequenz-Erzeugereinheit angeflanscht. Als Endstufe 7 kann sowohl eine kapazitiv mit dem Hochfrequenzgenerator verbundene Elektrode eingesetzt werden. Vorteilhafter ist es jedoch, wenn der Spannungswandler direkt innerhalb der Beschichtungskammer 1 als Endstufe 7 an der Substrathalterung 3 angeordnet ist.

Zur Abscheidung einer Polymerschicht auf der freien Oberfläche der Substrate 2 wird nach entsprechender Vorbehandlung über den Gaseinlaß 6 in die Beschichtungskammer 1 das entsprechende Monomer eingelassen und die Hochfrequenz-Endstufen 7 mit Strom versorgt. Damit wirken die metallischen Oberflächen der Substrate 2 als Elektrode der Hochfrequenz-Gasentladung ausgehend von der jeweiligen Hochfrequenz-Endstufe 7. Als andere Elektrode der Hochfrequenz-Gasentladung können sowohl die anderen Hochfrequenz-Endstufen 7 wirken oder auch die Beschichtungskammer 1. Vorteilhaft ist es, die einzelnen Hochfrequenz-Endstufen 7 in der zentralen Stromversorgung 8 derart zu schalten, daß der Entladungsstromkreis im wesentlichen immer über die Substrate 2 geschlossen wird. Die Anordnung ist dabei bezüglich des Massepotentials der Beschichtungskammer 1 elektrisch symmetrisch geschaltet.

Innerhalb der Hochfrequenz-Gasentladung bildet sich konzentriert an der Oberfläche der Substrate 2 ein homogenes Plasma aus, in dem das anwesende Monomer polymerisiert und sich als Polymerschicht 10 auf der Oberfläche abscheidet. Die Substrathalterung 3 ist mit einer Plasmablende 9 abgeschirmt, damit dort keine unerwünschte Abscheidung erfolgt.

### Ausführungsbeispiel II

Im Ausführungsbeispiel II wird die Erfindung in einer größeren Chargenanlage dargestellt. In der Beschichtungskammer 12 befindet sich ein Substratträgerwagen 13, der chargenweise mit Substraten 2 zur Beschichtung in die Beschichtungskammer 12 eingebracht wird.

Die Substrate 2 sind im Ausführungsbeispiel zu je zwei Gruppen A und B auf einem Substratträger 14 angeordnet. Dabei sind die beiden Gruppen A und B der Substrate 2 gegeneinander isoliert. Jede der beiden Gruppen von Substraten 2 ist in leitfähigen Substrathalterungen 15 gehaltert und bildet elektrisch eine Einheit. Jeweils seitlich ist an den Substrathalterungen 15 eine Endstufe 16 einer Hochfrequenz-Erzeugereinheit angeordnet.

Die einzelnen Substratträger 14, in Abhängigkeit der Größe der Substrate 2, z. B. vier bis 12 Stück, sind isoliert zueinander drehbar im Substratträgerwagen 13 angeordnet. Die getrennte elektrische Kontaktierung der einzelnen Endstufen 16 und damit der Substrathalterungen 15 mit der zentralen Stromversorgungseinrichtung 17 erfolgt je nach technischer Gegebenheit über Schleifringe, Rollkörper oder ähnliche Mittel.

Erfindungsgemäß ist jede Substrathalterung 15 mit den Substraten 2 eine getrennte selbständige Elektrode einer einzelnen von mehreren Hochfrequenz-Gasentladungen. Die Reflektorkörper werden als Substrate 2 aus einem Kunststoff zuerst mit einer Reflexionsschicht aus Aluminium beschichtet. Dazu wird das Aluminium im Vakuum von den Verdampfern 18 aus mittels Vakuumverdampfung auf den Substraten 2 abgeschieden. Dabei bildet sich über der gesamten offenen Oberfläche aller Substrate 2 und Substrathalterungen 15 eine einheitliche metallisch leitende Schicht 21 aus, die später bei der Hochfrequenz-Gasentladung als einheitliche Elektrode wirkt.

Nach der erforderlichen Vorbehandlung wird im Ausführungsbeispiel in die Beschichtungskammer 12 über den Gaseinlaß 22 und den Gasverteiler 19 Hexamethyldisiloxan [HMDSO - Si₂O(CH₃)₆] als Monomer und Sauerstoff (O₂) als Zusatzkomponente eingelassen. Nachdem die einzelnen Endstufen 16 über die zentrale Stromversorgungseinrichtung 17 mit Strom versorgt werden und eine plasmaerzeugende hochfrequente Spannung abgeben, bildet sich eine Gasentladung mit einem konzentrierten Plasmasaum über der gesamten leitfähigen Oberfläche der Substrate 2 und der Substrathalterungen 15 aus. In diesem Plasma kommt es zur intensiven Polymerisation des HMDSO-Monomers unter Einlagerung von Sauerstoff und zur Abscheidung einer HMDSO-O-Polymerschicht 20. Die Regelung der plasmaerzeugenden hochfrequenten Spannung über alle Endstufen 16 erfolgt dabei derart, daß jeweils die benachbarten Substrathalterungen 15 mit den Gruppen A bzw. B der Substrate 2 an einem entgegengesetzten Potential liegen, derart daß die Hochfrequenz-Gasentladung im wesentlichen zwischen den einzelnen Gruppen A und B auf den Substrathalterungen 15 abläuft.

Die HMDSO-O-Polymerschicht 20 wird nach dieser erfindungsgemäßen Verfahrensführung sehr effektiv mit hoher Abscheidegeschwindigkeit aufgebaut und ist sehr homogen. Die unerwünschte Abscheidung von Polymerschichten an anderen Einrichtungs-Bauteilen wird stark reduziert.

Die elektrische Schaltung der Substrathalterungen 15 kann bei ähnlichem Erfolg auch asymmetrisch erfolgen, wobei die Substrathalterungen 15 mit den Substraten 2 an der plasmaerzeugenden hochfrequenten Spannung liegen und die Beschichtungskammer 12 als Gegenelektrode geschaltet ist.

### Liste der verwendeten Positionsnummern

| | | | |
|---|---|---|---|
| 1 | Beschichtungskammer | 2 | Substrat |
| 3 | Substrathalterung | 4 | Isolierkörper |
| 5 | Vakuumanschluß | 6 | Gaseinlaß |
| 7 | Endstufe | 8 | Stromversorgung |
| 9 | Plasmablende | 10 | Polymerschicht |
| 11 | | 12 | Beschichtungskammer |
| 13 | Substratträgerwagen | 14 | Substratträger |
| 15 | Substrathalterung | 16 | Endstufe |
| 17 | Stromversorgungseinrichtung | 18 | Verdampfer |
| 19 | Gasverteiler | 20 | Polymerschicht |
| 21 | leitende Schicht | 22 | Gaseinlaß |
| 23 | | 24 | |
| 25 | | 26 | |
| 27 | | 28 | |
| 29 | | 30 | |

## Patentansprüche

1. Verfahren zur Hochfrequenz-Plasmapolymerisation für die Abscheidung von Polymerschichten auf der Oberfläche von Substraten in einer Beschichtungskammer, bei dem ein monomerer Dampf einer organischen Verbindung unter der Wirkung einer Hochfrequenz-Gasentladung polymerisiert wird, wobei die Substrate als Elektrode der Hochfrequenz-Gasentladung geschaltet werden, **dadurch gekennzeichnet, daß** die plasmaerzeugende hochfrequente Spannung innerhalb der Beschichtungskammer (1, 12) und im wesentlichen in unmittelbarer Nähe der Substrate (2) oder der Substrathalterungen (3, 15) erzeugt wird.

2. Verfahren nach Anspruch 1, **dadurch gekennzeichnet, daß** bei einer Vielzahl von Substraten (2) die plasmaerzeugende hochfrequente Spannung jeweils unabhängig voneinander und in unmittelbarer Nähe jedes Substrates (2) oder jeder Gruppe von Substraten erzeugt werden.

3. Verfahren nach Anspruch 2, **dadurch gekennzeichnet, daß** an den einzelnen Substraten (2) oder an den Gruppen von Substraten die einzelnen plasmaerzeugenden hochfrequenten Spannungen mit alternierender bzw. ausgleichender Frequenz-Amplitude erzeugt werden.

4. Verfahren nach einem der Ansprüche 1 bis 3, **dadurch gekennzeichnet, daß** die einzelnen Substrate (2) und die Substrathalterungen (15) vor der Plasmapolymerisation gemeinsam mittels Vakuumbedampfung mit einer dünnen leitfähigen Schicht beschichtet werden, die in der Folge während der Plasmapolymerisation als Elektrode der Hochfrequenz-Gasentladung geschaltet wird.

5. Einrichtung zur Hochfrequenz-Plasmapolymerisation für die Abscheidung von Polymerschichten auf der Oberfläche eines Substrates in einer Beschichtungskammer, wobei ein monomerer Dampf einer organischen Verbindung unter der Wirkung einer Hochfrequenz-Gasentladung polymerisiert wird und die Substrate oder die Substrathalterung als Elektrode der Hochfrequenz-Gasentladung geschaltet sind, **dadurch gekennzeichnet, daß** die Endstufe (7, 16) der Hochfrequenz-Erzeugereinheit innerhalb der Beschichtungskammer (1, 12) angeordnet und unmittelbar mit dem Substrat (2) oder der Substrathalterung (3, 15) elektrisch kontaktiert ist.

6. Einrichtung zur Hochfrequenz-Plasmapolymerisation für die Abscheidung von Polymerschichten auf der Oberfläche von Substraten in einer Beschichtungskammer, wobei ein monomerer Dampf einer organischen Verbindung unter der Wirkung einer Hochfrequenz-Gasentladung polymerisiert wird und die Substrate oder Substrathalterungen als Elektrode der Hochfrequenz-Gasentladung geschaltet sind, **dadurch gekennzeichnet, daß** die Substrate (2) oder einzelne Gruppen von Substraten in der Beschichtungskammer (1, 12) gegeneinander isoliert angeordnet sind und daß jedes Substrat (2) bzw. jede Gruppe von Substraten (2) oder die Substrathalterungen (3, 15) mit einer innerhalb oder außerhalb der Beschichtungskammer (1, 12) in unmittelbarer räumlichen Nähe angeordneten separaten Endstufe (7, 16) einer Hochfrequenz-Erzeugereinheit elektrisch verbunden sind.

7. Einrichtung nach Anspruch 6, **dadurch gekennzeichnet, daß** bei Durchlaufanlagen als Substrathalterung Substratträger vorhanden sind, an denen je eine einzelne separate Endstufe einer Hochfrequenz-Erzeugereinheit angeordnet ist.

8. Einrichtung nach einem der Ansprüche 5 bis 7, **dadurch gekennzeichnet, daß** die Substrate (2) und die Substrathalterungen (15) derart zueinander ausgerichtet sind, daß mindestens eine der aneinandergrenzenden Umrißkanten eine Ebene bilden und eng aneinanderliegen.

## Claims

1. Process for high-frequency plasma polymerization for the deposition of polymer layers on the surface of substrates in a coating chamber, in which a monomeric vapour of an organic compound is polymerized under the action of a high-frequency gas discharge, the substrates being connected as electrode of the high-frequency gas discharge, **characterized in that** the plasma-generating high-frequency voltage is generated within the coating chamber (1, 12) and essentially in direct proximity to the substrates (2) or the substrate mounts (3, 15).

2. Process according to Claim 1, **characterized in that**, in the case of a multiplicity of substrates (2), the plasma-generating high-frequency voltage is in each case generated independently of one another and in direct proximity to each substrate (2) or each group of substrates.

3. Process according to Claim 2, **characterized in that**, at the individual substrates (2) or at the groups of substrates, the individual plasma-generating high-frequency voltages are generated with alternate or compensating frequency amplitude.

4. Process according to one of Claims 1 to 3, **characterized in that** the individual substrates (2) and the substrate mounts (15) are jointly coated with a thin conductive layer by means of vacuum vapour deposition prior to the plasma polymerization, which layer is subsequently connected as electrode of the high-frequency gas discharge during the plasma polymerization.

5. Apparatus for high-frequency plasma polymerization for the deposition of polymer layers on the surface of a substrate in a coating chamber, a monomeric vapour of an organic compound being polymerized under the action of a high-frequency gas discharge and the substrates or the substrate mount being connected as electrode of the high-frequency gas discharge, **characterized in that** the output stage (7, 16) of the high-frequency generator unit is arranged within the coating chamber (1, 12) and electrically contact-connected directly to the substrate (2) or the substrate mount (3, 15).

6. Apparatus for high-frequency plasma polymerization for the deposition of polymer layers on the surface of substrates in a coating chamber, a monomeric vapour of an organic compound being polymerized under the action of a high-frequency gas discharge and the substrates or substrate mounts being connected as electrode of the high-frequency gas discharge, **characterized in that** the substrates (2) or individual groups of substrates are arranged in a manner insulated from one another in the coating chamber (1, 12), and **in that** each substrate (2) or each group of substrates (2) or the substrate mounts (3, 15) are electrically connected to a separate output stage (7, 16) of a high-frequency generator unit, which output stage is arranged in direct spatial proximity within or outside the coating chamber (1, 12).

7. Apparatus according to Claim 6, **characterized in that**, in the case of flow-type installations, substrate carriers are present as substrate mount, an individual separate output stage of a high-frequency generator unit in each case being arranged on said substrate carriers.

8. Apparatus according to one of Claims 5 to 7, **characterized in that** the substrates (2) and the substrate mounts (15) are oriented with respect to one another in such a way that at least one of the adjoining contour edges form a plane and lie closely adjacent to one another.

## Revendications

1. Procédé pour la polymérisation dans un plasma à haute fréquence pour le dépôt de couches de polymère sur la surface de substrats dans une chambre de revêtement, dans lequel une vapeur de monomères d'un composé organique est polymérisée sous l'effet d'une décharge à haute fréquence dans un gaz, les substrats étant commutés en électrodes pour la décharge à haute fréquence dans un gaz, **caractérisé en ce que** la tension de haute fréquence produisant le plasma est produite dans la chambre de revêtement (1, 12) et essentiellement à proximité immédiate des substrats (2) ou des dispositifs de fixation des substrats (3, 15).

2. Procédé selon la revendication 1, **caractérisé en ce que** dans le cas d'une multitude de substrats (2), la tension de haute fréquence produisant le plasma est produite à chaque fois indépendamment l'une de l'autre et à proximité immédiate de chaque substrat (2) ou de chaque groupe de substrats.

3. Procédé selon la revendication 2, **caractérisé en ce qu'**au niveau des différents substrats (2) ou des groupes de substrats, les différentes tensions de haute fréquence produisant le plasma sont produites avec une amplitude de fréquence alternative ou, selon le cas, de compensation.

4. Procédé selon l'une quelconque des revendications 1 à 3, **caractérisé en ce que** les différents substrats (2) et les dispositifs de fixation (15) des substrats sont revêtus ensemble avant la polymérisation dans un plasma au moyen d'une vaporisation sous vide par une couche mince conductible, qui est commutée par la suite, pendant la polymérisation dans un plasma, en électrode pour la décharge à haute fréquence dans un gaz.

5. Dispositif pour la polymérisation dans un plasma à haute fréquence pour le dépôt de couches de polymère à la surface d'un substrat dans une chambre de revêtement, une vapeur de monomères d'un composé organique étant polymérisée sous l'effet d'une décharge à haute fréquence dans un gaz et les substrats ou le dispositif de fixation des substrats étant commutés en électrode pour la décharge à haute fréquence dans un gaz, **caractérisé en ce que** l'étage final (7, 16) de l'unité de production de la haute fréquence est disposé dans la chambre de revêtement (1, 12) et est mis électriquement en contact directement avec le substrat (2) ou le dispositif de fixation (3, 15) du substrat.

6. Dispositif pour la polymérisation dans un plasma à haute fréquence pour le dépôt de couches de polymère à la surface de substrats dans une chambre de revêtement, une vapeur de monomères d'un composé organique étant polymérisée sous l'effet d'une décharge à haute fréquence dans un gaz et les substrats ou les dispositifs de fixation des substrats étant commutés en électrode pour la décharge à haute fréquence dans un gaz, **caractérisé en ce que** les substrats (2) ou les différents groupes de substrats sont disposés dans la chambre de revêtement (1, 12) en étant isolés les uns des autres et **en ce que** chaque substrat (2) ou, selon le cas, chaque groupe de substrats (2) ou les dispositifs de fixation des substrats (3, 15) sont raccordés électriquement avec un étage final (7, 16) d'une unité de production de la haute fréquence, séparé disposé à proximité immédiate, à l'intérieur ou à l'extérieur de la chambre de revêtement (1, 12).

7. Dispositif selon la revendication 6, **caractérisé en ce que** dans le cas d'installations continues, des supports de substrats sont présents comme dispositif de fixation de substrat, sur lesquels on a disposé à chaque fois un étage final séparé différent d'une unité de production de la haute fréquence.

8. Dispositif selon l'une quelconque des revendications 5 à 7, **caractérisé en ce que** les substrats (2) et les dispositifs de fixation des substrats (15) sont orientés l'un par rapport à l'autre de telle manière qu'au moins un des côtés périphériques adjacents forment un plan et sont disposés en étant proches l'un contre l'autre.
